# EUROPEAN PATENT SPECIFICATION

(11) **EP 1 363 292 B1**
(45) Date of publication and mention of the grant of the patent: **08.08.2012**
(21) Application number: 03010684.3
(22) Date of filing: 13.05.2003
(51) Int. Cl.: G11C 16/10, G11C 11/56

(54) **Programming method of the memory cells in a multilevel non-volatile memory device**
Programmierverfahren von Speicherzellen in einer nichtflüchtigen Mehrpegelspeicheranordnung
Procédé de programmation de cellules de mémoire dans un dispositif de mémoire nonvolatile multiniveaux

(30) Priority: 13.05.2002 EP 02425293
(43) Date of publication of application: 19.11.2003
(73) Proprietor: STMicroelectronics Srl, 20864 Agrate Brianza (IT)
(72) Inventor: Pascucci, Luigi, 20099 Sesto San Giovanni (Milano) (IT); Rolandi, Paolo, 27058 Voghera (Pavia) (IT); Riva, Marco, 24040 Lallio (Bergamo) (IT)
(74) Representative: Niederkofler, Oswald

(56) References cited:
- JP-A- 2002 124 091
- US-A- 5 553 020
- US-A- 5 708 600
- US-A- 5 796 652
- US-A- 5 831 901
- US-A- 5 970 012
- OHKAWA M ET AL: "A 98 MM2 DIE SIZE 3.3-V 64-MB FLASH MEMORY WITH FN-NOR TYPE FOUR- LEVEL CELL" IEEE JOURNAL OF SOLID-STATE CIRCUITS, IEEE INC. NEW YORK, US, vol. 31, no. 11, 1 November 1996 (1996-11-01), pages 1584-1589, XP000691442 ISSN: 0018-9200

## Description

### Field of Application

The present invention relates to a method for programming the memory cells of a multi-level non-volatile memory device.

More particularly, the invention relates to a method of programming a non-volatile memory device of the multi-level type, which device comprises a plurality of transistor cells grouped into memory words and provided with conventional gate and drain terminals.

The invention relates, particularly but not exclusively, to a multi-level non-volatile memory device monolithically integrated in a semiconductor, and the following description is made with reference to this application field for convenience of illustration only.

### Prior Art

As it is well known, in a two-level memory device that employs a floating gate MOS transistor as elementary cell, the threshold voltage of the cell can be modulated to establish either of two logic states. A first logic state (logic "1") corresponds to a situation of the floating gate containing no charge, as is typical of a virgin or an erased cell, for example. Another logic state (logic "0") corresponds to the floating gate storing a sufficient number of electrons to produce a dramatic rise of its threshold, thereby denoting the programmed state of the cell.

A current-read method can be used for reading a memory cell 1, which consists of applying a read voltage Vread to the gate terminal of the cell and reading the current that flows through the cell:
- if the cell is a written cell, its threshold voltage will be higher than the read voltage Vread, so that no current will flow through the cell; otherwise
- if the cell is an erased cell, its threshold voltage must be adequate to admit a current through the cell.

To read information contained in memory cells of this type, a sense amplifier is used which compares the cell current with a reference value, thus converting the analog information of the addressed data in the cell, i.e. the value of the cell threshold voltage, to digital information, i.e. to a logic "0" or a logic "1".

Non-volatile memory devices, particularly those of the EEPROM and FLASH types, are specially adapted to store up large amounts of data, and are widely used, for example, in the presently expanding digital video and audio fields. In fact, digital video and audio applications require higher and higher storage capacities in order to store a large number of musical songs in the same support, or to enhance image quality, such as by an increased number of imaging pixels.

Multi-level non-volatile memories have recently appeared on the market, which are memories capable of storing a multiplicity of information bits in each cell. Such memories look specially well equipped to fill the above demands.

In this type of multi-level memories, the charge stored in the floating gate is further broken up, thereby generating a number 2^{nb} of distributions, where "nb" is the number of bits that are to be stored in a single cell. For example, with 2 bits per cell, the read sense amplifier is to process four distributions, instead of two as in the two-level instance.

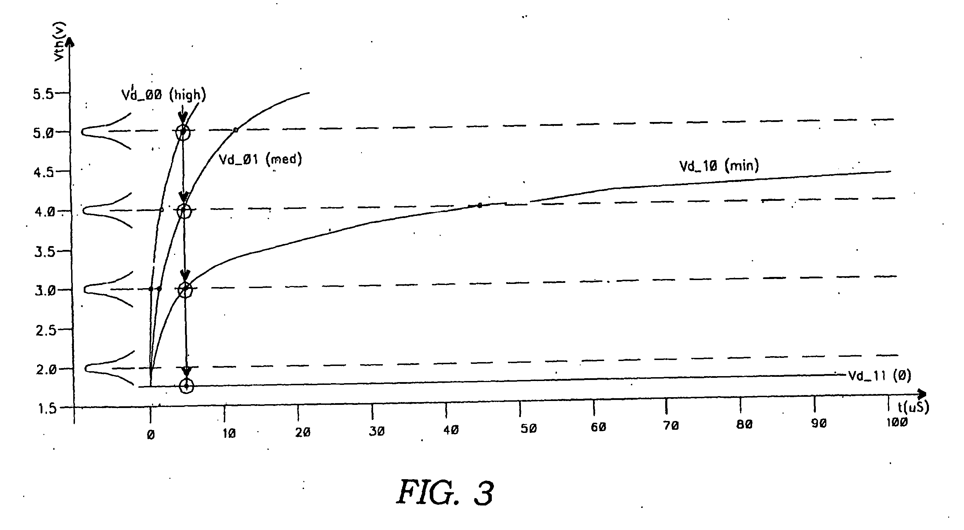

A comparison of the threshold voltage distribution for a two-level memory and a multi-level memory with two bits per cell is schematically illustrated in Figures 3A and 3B. It can be seen that the multi-level structure decreases the gap between the voltage values and increases the read voltage.

It should be noted that the working range of the threshold voltage is independent of the number of bits contained in the cell. Thus, by employing a multi-level structure, the threshold gap between the various distributions decreases.

Reducing the gap between the threshold voltage distributions means reducing the current differences that the sense amplifier is to sense. Furthermore, it should be provided a programming method, able to place the cells inside the various distributions.

For convenience of illustration only, the instance of a flash EEPROM with NOR architecture will be considered herein below.

As it is well known, memory cells of this type are written by hot electron injection, by applying a voltage of about 10 V to the control gate terminal , a voltage of about 5 V to the drain terminal , and by leaving the source terminal connected to a ground reference, thereby allowing the floating gate terminal to accumulate charge to saturation.

In the instance of a multi-level memory, the reduction of the difference between the threshold voltages corresponding to the various charge levels that can be stored in the floating gate terminal, and hence the difference between the various conduction levels of the cells, requires an accurate and "fine" control of the cell programming operation, and in particular of the charge stored in the floating gate terminal during such an operation.

It has been shown, both theoretically and experimentally, that a linear relation exists between the variation ΔVG of the voltage applied to the control gate terminal during the cell programming phase and the threshold jump that is obtained at set values of the voltage VD applied to the drain terminal and of the voltage VS to the source terminal, as explained by Ricco et al. in an article "Nonvolatile multilevel memories for digital application", Pro. IEEE, vol. 86, December, 1998, pages 2399-2421.

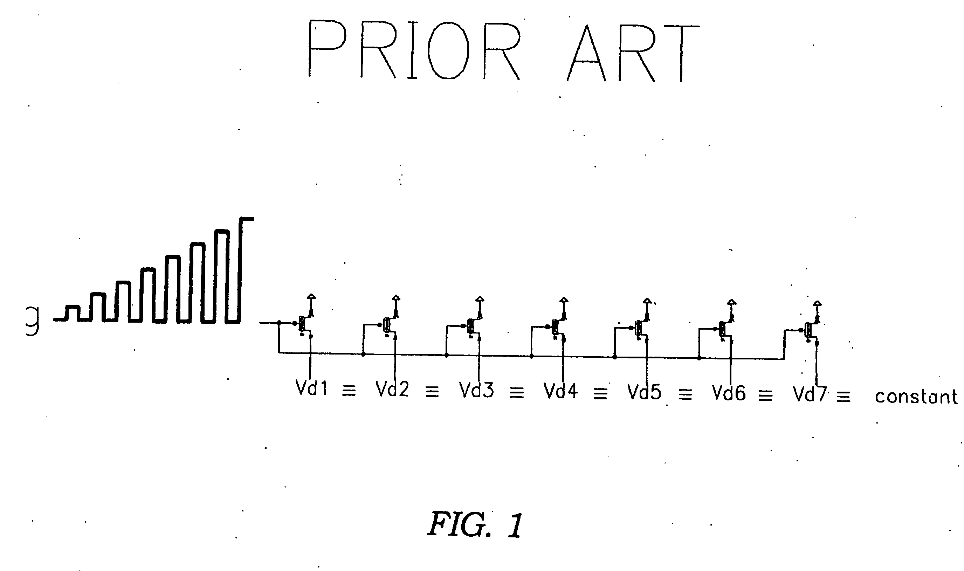

In particular, as schematically shown in Figure 1, the cell should be programmed by applying, to its control gate terminal, a "stepwise" voltage that increases linearly.

In practice, a series of program pulses are used which differ from each other by a constant value ΔVG. Thus, the program voltage is a constant pitch stepwise ramp, while the voltage on the drain terminal and the pulse duration are dependent on and set by the cell fabrication process.

At the end of each program pulse, the result is verified to see if the desired threshold level has been attained, and to discontinue or to continue programming accordingly, as disclosed in US 5,553,020.

It can be appreciated that, when this programming method is used, a threshold voltage distribution of width ΔVG is obtained, which equals the pitch of the stepwise program voltage.

Thus, multi-level memory cells can be programmed at a desired threshold voltage by using a predetermined number of program pulses.

The main problem encountered with the above method is its inherently low speed. Programming multi-level cells involves applying a succession of pulses to the control gate of the cell, starting from the lowest level, and this takes a longer time than the single programming pulse used in the case of two-level cells. In addition, each level is attained only after the setting of the level directly below. This happens also in the solution disclosed in US 5,970,012.

In order to achieve a programming time of the single byte that can be compared with that of a conventional two-level cell, it has been thought of programming several multi-level cells in parallel.

Assuming 8 µs to be the time taken to program a single byte in the two-level case, and 200 µs to be the time taken to go through the stepwise program ramp in the multi-level case, then 32 bits of multi-level cells would have to be programmed simultaneously in order to achieve an effective programming time of 6 µs per each single byte of multi-level cells.

Increasing the internal parallelism of multi-level memory devices would bring about several technical problems, first and foremost increased current usage, to the point that any engineering developments in that direction would be restrained.

As an alternative to the previous solution it has been proposed to write a multi-level non-volatile memory device comprising a plurality of transistor cells grouped into memory words and provided with conventional gate and drain terminals by different drain voltage values applied in parallel to separate cells for attaining different threshold values.

This solution is disclosed for instance in the US patent No. 5,796,652 assigned to NEC and disclosing a memory cells array including a first and a second writing circuits generating a first and a second writing voltages having a level corresponding to the value of a first and a second quaternary input data.

So, two items of quaternary data can be simultaneously written into two multi-level memory cells of one memory row selected by one word line.

The principle of operation for writing a multivalue information into the memory cells is disclosed with reference to figure 9. The gate of each selected memory cell transistor receives a negative writing voltage while the drain of the same transistor receives one of the available four voltages corresponding to the desired threshold voltages.

However, as shown in figure 10 of that patent, the writing bit line voltages are applied for a programming time Tp that is difficult to control and will not be able to reach always the target values without overlapping with or getting closer to different logic values of the cell.

Moreover, the circuit structure for applying the require writing voltages is very complex and uses a couple of switch transistors for each bit line to bias.

Similar solutions are disclosed also in the US patent No. 5,708,600 and in the US patent No. 5,970,012. Both solution, however, fail to reach efficient programming results in reasonable times of with writing circuit of reduced complexity.

The underlying technical problem of this invention is to provide a new method of programming the cells of a multi-level non-volatile memory device, which method has appropriate operational features to enable programming to be performed faster than, yet as accurately as, the programming methods of the prior art.

### Summary of the Invention

The solution idea of the present invention is that of applying, to the drain terminals of the cells of a given memory word to be programmed, different voltage values as a function of the threshold to be attained. The different drain voltages, each corresponding to a predetermined level, are selected to promote the attainment of the corresponding level in a seeking-to or asymptotic way, i.e. after a congruous number of pulses, regardless of the final level of each bit.

The different drain voltage values are directly proportional to the threshold values to be attained for each bit, and are selected such that the corresponding level set for each bit is attained in a seeking-to or asymptotic manner at the end of a congruous number of pulses.

Of course, to obtain bits of equal level, the same drain voltage values have to be applied.

The congruous number of pulses is to meet two requirements: it should be the least possible, and at the same time, ensure that each level is attained with an appropriate degree of suitable and controlled accuracy.

Based on this idea, the technical problem is solved by a programming method as defined in Claim 1.

The features and advantages of the programming method according to this invention will become apparent from the following description of an embodiment thereof, given by way of non-limitative example with reference to the accompanying drawings.

### Brief Description of the Drawings

In the drawings:
- Figure 1 schematically shows schematically a series of multi-level memory cells and a plot of a programming voltage to be applied to the cell control gate terminals, according to the prior art;
- Figure 2 schematically shows the same series of multi-level memory cells as in Figure 1, and a plot of a programming voltage to be applied to the cell drain terminals, according to this invention;
- Figure 3 schematically shows a plot of voltage against time showing certain characteristic curves that correspond to different threshold levels of the memory cells;
- Figures 4A and 4B schematically show voltage vs. time plots respectively showing two different characteristic curves associated with a predetermined logic level that vary depending on the number of pulses applied to the drain terminals of the memory cells; and
- Figures 5A and 5B schematically show voltage vs. time plots respectively showing two different characteristic curves associated with a predetermined logic level and that vary depending on the number of pulses applied to the drain terminals of the memory cells;
- Figure 6 is a schematic view of a writing circuit portion incorporated into a memory device of the present invention.

### Detailed Description

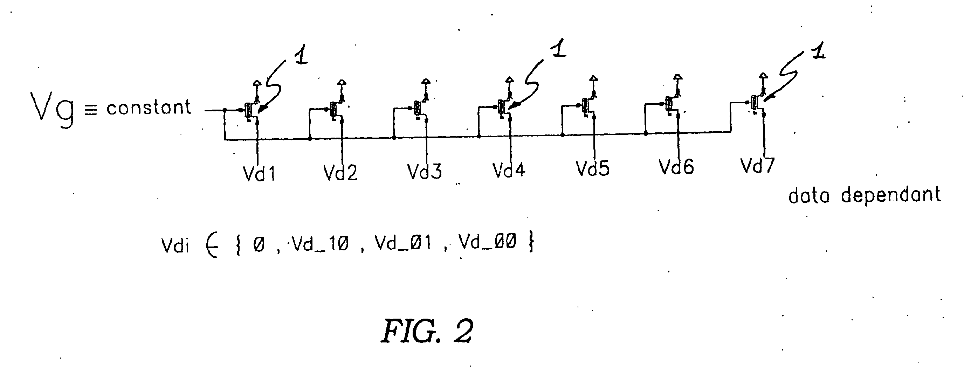

With reference to the drawings, in particular to Figure 2 thereof, a group of memory cells, being incorporated to a multi-level non-volatile memory device monolithically integrated in a semiconductor, are shown generally at 1 in schematic form.

The memory device is a conventional one, and accordingly shown in the drawings as a whole. It comprises an array of multi-level memory cells along with its address, decode, read, write, and erase circuitry. Thus, shown in Figure 1 is just an eight-bit memory word or byte.

However, there is no reason why larger memory words, e.g. words of sixteen, thirty-two, or sixty-four bits, could not be considered instead. The following considerations bear no relation to the size of the memory word.

The memory device where the cells 1 are incorporated may be of the EEPROM or of the flash EEPROM, and is electrically programmable and erasable.

As previously stated, the array of non-volatile memory cells has conventional decode circuitry associated therewith, which circuitry is triggered by a switching edge of a pulsive signal ATD.

A typical architecture of a non-volatile memory array comprises a number of sectors divided into two groups. Each sector can be programmed and erased independently of the other sectors. Furthermore, each group has its own row decode, and its own array of read sense amplifiers.

A more detailed description of the construction and operation of a multi-level memory device can be found in the technical literature. For the purpose of this invention, it is important to understand that, in a multi-level memory device, the duration of the programming pulse and the voltage applied to the drain terminal of the memory cell are critical parameters to successful programming.

In conventional programming of the stepwise type, carried out according to the prior art, a memory cell typically draws a current of several tens of µA. For example, assuming a current draw of 50 µA per cell, programming or modifying 64 cells in parallel would require a total program current of 3.2 mA.

The method of the invention allows the current requirements for programming to be drastically reduced, and allows much faster programming.

With reference in particular to the example shown in Figure 2, the control gate terminals of the memory cells 1 that comprise the memory word are all held at the same constant voltage value Vg.

At the same time, to the drain terminal of each memory cell is applied a drain voltage that is a direct function of the threshold level sought to be reached for a predetermined bit. The voltage values to be applied to the drain terminal, say four different values for four different levels, are purposely selected from an indefinite set of possible values, such that the target condition can be simultaneously attained, regardless of the values of the levels. This is achieved with a limited, albeit exactly congruous, number of pulses, which are followed by a testing phase.

This is made practicable by the drain levels being designed to produce larger variations at higher levels, such that they can attain a respective level each at the end of a convenient number of pulses.

In this way, a different final threshold voltage can be obtained for each cell at the very instant of time when programming is discontinued.

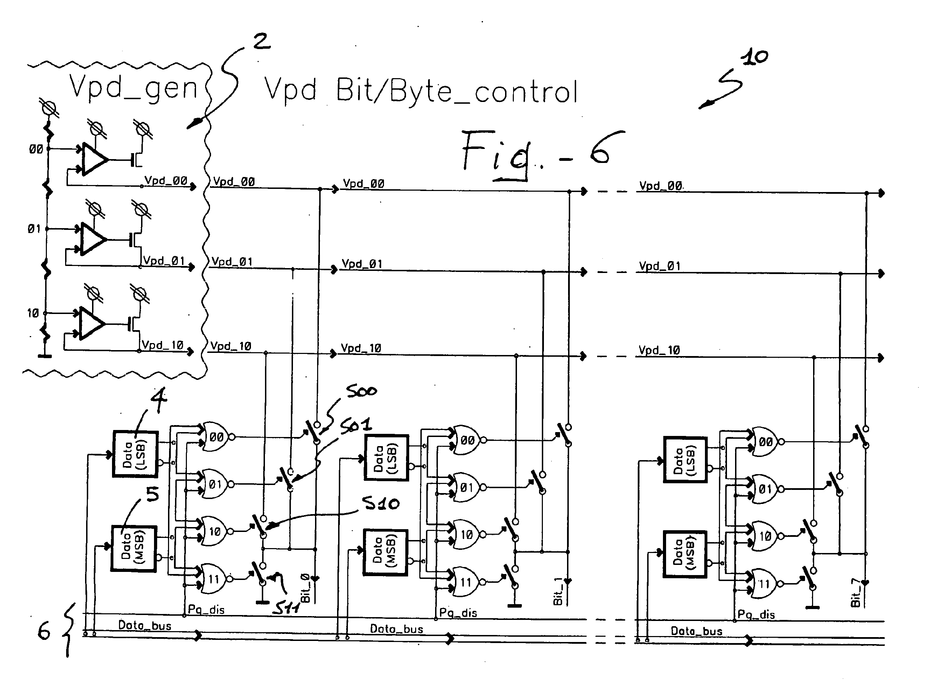

A writing circuit portion 10 for programming the multi-level memory cells according to the present invention is shown in Figure 6.

This circuit portion includes a voltage generator 2 providing for instance three different output voltage values, each corresponding to a logic level to be programmed in the memory cells, i.e. the logic level 00, 01 and 10. A fourth reference voltage is obtained from the ground voltage reference for the logic level 11.

The voltage regulator 2 includes three independent voltage regulators each providing on a output line a predetermined output voltage level.

In more general terms it may be appreciated that the output lines of the voltage generator 2 are n-1 where n is the number of levels of each multi-level memory cell.

The voltage regulators of the voltage generator 2 are supplied by a stable voltage reference, for instance a bandgap voltage reference.

According to the present invention each bit line Bit_0, Bit_1,..., Bit_7 of a memory word is connected to the outputs of the voltage generator 2 through a corresponding switch S00, S01, S10 and S11.

Each switch is driven by the output of a corresponding logic gate G00, G01, G10 and G11.

Those logic gates present two inputs, one connected to a disabling line Pg_dis and the other receiving a signal from the output of data block. More particularly, a first data block 4 for he less significant bit is coupled to the first gates G00 and G01, while a second data block 5 for the most significant bits is coupled to the other gates G10 and G11.

Each data block is input connected to a Data_bus 6 receiving the input data to be written into the memory cells.

As may be appreciated, just a single switch is enabled by the corresponding logic gate to bias the bit line of the memory array with the right voltage value provided by the voltage generator 2.

According to the selection performed by the data block 4 and 5, one of the logic gates G00, G01, G10 and G11 is enabled to drive the corresponding switch thus connecting the selected bit line with the output voltage line.

In case of larger memory words, e.g. words of sixteen, thirty-two, or sixty-four bits, all the bit lines may be coupled to the same output lines above disclosed. In this manner a more word including more than one byte can be simultaneously configured under control of the data block 4 and 5 for a larger parallel programming but using always the same output lines of the voltage regulator 2.

So, the writing circuit portion 10 provides n-1 different drain voltages produced by dedicated voltage regulators. Each voltage regulator can be simultaneously applied to many different drain terminals having the same voltage level to be reached.

The aspects of the invention can be better appreciated by having reference to the graph of voltage vs. time in Figure 3.

The graph shows curves of measurements made by the Applicant on electrically programmable/erasable multi-level non-volatile cells.

The curves show that the write characteristic of the cells varies with time and the value of the drain voltage at constant gate voltage, e.g. of 9 V.

The cell threshold increases with time and according to the end level sought, while at a predetermined instant of time, it takes a value that corresponds to the drain voltage applied.

In essence, after a predetermined period of time, the threshold voltage of a given cell held at a constant control gate voltage will have a threshold value that is tightly linked to the voltage applied to its drain terminal. The higher this voltage value, the higher will be the corresponding threshold. The drain voltage values are selected such that the different levels will be attained simultaneously after n congruously accurate pulses, whose number may be a bare minimum.

Of course, the minimum number of preceding pulses is tightly linked to the degree of accuracy sought. However, by paralleling the levels in this manner, some more pulses can be expended to enhance the degree of accuracy, with the inventive method providing the dual advantage of being faster and more accurate than traditional approaches.

Consequently, the method of this invention essentially dissociates the memory cell programming time from a target threshold level.

In conventional stepwise programming methods, programming time is a linear function of the level to which a given cell is to be raised, and many pulses are expended to just move from one level to another, with an attendant waste of time.

In addition, as the plot of Figure 3 brings out, attaining a given threshold level in a non-linear, or rather logarithmic fashion versus time is assurance of the threshold levels, and hence the corresponding logic levels, being neatly separated. In essence, the possibility for levels to overlap is drastically lessened.

A noteworthy feature of the programming method of this invention is that to the drain terminals of the cells are applied successive voltage pulses of predetermined duration, e.g. 1 µs, and of a level same as the level sought. However, there is no reason why successive pulses of different duration could not be used instead, e.g. a first pulse of long duration followed by one or more pulses of shorter or decreasing duration, in order to advantageously speed up the starting step and further reduce the number of pulses and attendant verify step.

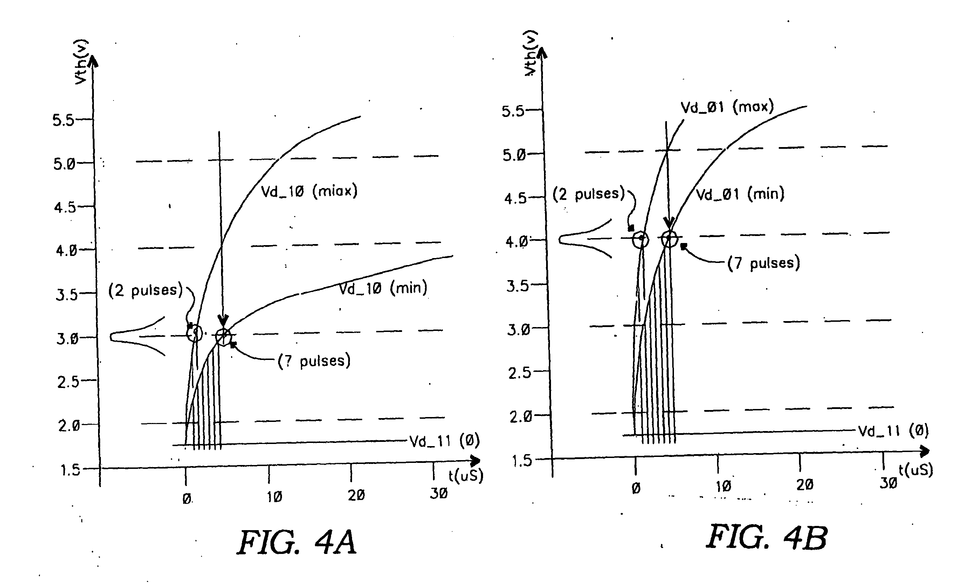

The voltage/time graph of Figure 4A shows, by way of example, two characteristic curves illustrating how the attainable threshold values may vary for the same applied voltage values but with a different number of pulses.

The voltage/time graph of Figure 4B is another example obtained at a different drain voltage level if compared with the graph of Figure 4A.

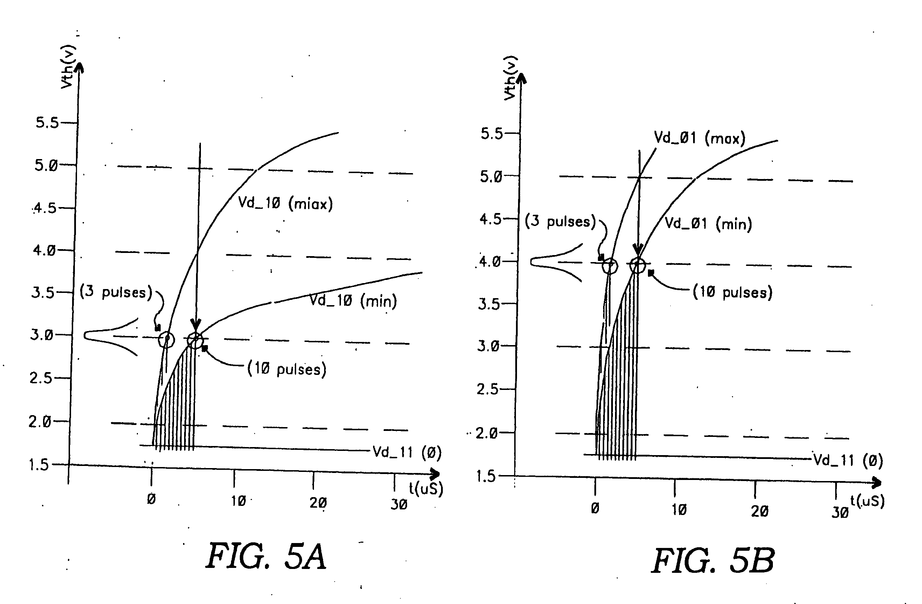

The graphs of Figures 5A and 5B are similar to those of Figures 4A and 4B, but for the number of pulses that are applied in order to attain a predetermined threshold.

The number of pulses that can be applied to the drain terminal may vary contingent on the cell fabrication process, and can be adjusted according to the results of conventional program verify tests.

The method of this invention does brilliantly solve the technical problem, and provides a number of advantages, foremost among which is that the number of pulses, and with it the memory word programming time, has been greatly reduced if compared with conventional methods.

Simulation tests conducted by the Applicant have demonstrated time savings of up to one order of magnitude over gate pulse writing.

The solution proposed by the present invention outdates the parallelism techniques.

An additional advantage comes from the reduced stress on the gates of the memory cells. In the state of the art, one is to wait for all the cells of a byte to be written before a memory address can be changed, which highly stresses the gate terminals with the application of the whole stepwise ramp of voltage values. On the other hand, the amount of stress on the gate terminals is reduced in this invention, again of one order of magnitude.

Finally, it will be appreciated that, in this invention, the drain terminals of the cells to be programmed are brought up to a desired regulated voltage value, regardless of the number of cells that are to be programmed.

The programming method of this invention can also be advantageously applied to high-capacity memory devices having special functions (such as the burst mode or page mode) and including a large number of sense amplifiers arranged for sharing by the whole memory array.

## Claims

1. A method for programming a non-volatile multi-level memory device comprising a plurality of transistor cells grouped into memory words and provided with conventional gate and drain terminals, wherein different drain voltage values are applied in parallel to separate cells of a memory word for attaining different threshold values
**characterized in that**
said different drain voltage values are applied to said drain terminals by means of a succession of voltage pulses, are directly proportional to the threshold values to be attained for each cell and are selected such that the different target levels of said separate cells is are simultaneously attained in an asymptotic manner versus time at the end of a same number n of said drain voltage pulses;
a same constant gate voltage being concurrently applied to the gate terminals of said transistor cells of said memory word.

2. A programming method according to Claim 1, **characterized in that** the different drain voltages have a constant amplitude or level at each pulse.

3. A programming method according to Claim 1, **characterized in that** said pulses are constant duration pulses.

4. A programming method according to Claim 1, **characterized in that** said pulses are decreasing duration pulses.

5. A programming method according to Claim 1, **characterized in that** said pulses are varying duration pulses.

6. A programming method according to Claim 1, **characterized in that** the different drain voltage values correspond to different logic threshold values of the multi-level cells.

7. A programming method according to Claim 1, **characterized in that** said different drain voltage values are appropriate to ensure that a predetermined threshold level will be attained
at the end of a predetermined number n of pulses.

8. A programming method according to Claim 1, **characterized in that** said separate cells of said memory word have taken different individual target threshold values in an asymptotic manner, at the very instant of time when programming is interrupted.

9. A programming method according to Claim 1, **characterized in that** the cell programming time is unrelated to the threshold level sought.

10. A programming method according to Claim 1, **characterized in that** the point of simultaneous attainment of the different target levels is set at the end of said number n of pulses.

11. A programming method according to Claim 10, **characterized in that** said number n of pulses is set consistently with a congruous degree of accuracy and with said number n tending to a minimum.

12. A programming method according to Claim 1, wherein each drain voltage value is generated by a different and corresponding voltage regulator; the number of regulators being m-1 where m is the number of levels of the multi-level cells.

## Patentansprüche

1. Verfahren zum Programmieren einer nicht-flüchtigen Mehrpegelspeichervorrichtung umfassend eine Mehrzahl von Transistorzellen, welche zu Speicherwörtern gruppiert und mit konventionellen Gate- und Drainanschlüssen ausgestattet sind, wobei verschiedene Drainspannungswerte parallel an separate Zellen eines Speicherwortes angelegt werden, um unterschiedliche Schwellwerte zu erhalten,
**dadurch gekennzeichnet, dass**
die verschiedenen Drainspannungswerte an die Drainanschlüsse mittels einer Folge von Spannungsimpulsen angelegt werden, direkt proportional zu den Schwellwerten sind, die für jede Zelle erhalten werden, und derart ausgewählt werden, dass die verschiedenen Zielpegel der separaten Zellen gleichzeitig in einer asymptotischen Weise gegenüber der Zeit am Ende einer gleichen Anzahl n von Drainspannungsimpulsen erhalten werden;
eine gleiche konstante Gatespannung gleichzeitig an den Gateanschlüssen der Transistorzellen des Speicherwortes angelegt wird.

2. Programmierverfahren nach Anspruch 1, **dadurch gekennzeichnet, dass** die verschiedenen Drainspannungen eine konstante Amplitude oder Pegel bei jedem Impuls aufweisen.

3. Programmierverfahren nach Anspruch 1, **dadurch gekennzeichnet, dass** die Impulse eine konstante Impulsdauer aufweisen.

4. Programmierverfahren nach Anspruch 1, **dadurch gekennzeichnet, dass** die Impulse eine abfallende Impulsdauer aufweisen.

5. Programmierverfahren nach Anspruch 1, **dadurch gekennzeichnet, dass** die Impulse variierende Impulsdauern aufweisen.

6. Programmierverfahren nach Anspruch 1, **dadurch gekennzeichnet, dass** die verschiedenen Drainspannungswerte unterschiedlichen logischen Schwellwerten der Multipegelzellen entsprechen.

7. Programmierverfahren nach Anspruch 1, **dadurch gekennzeichnet, dass** die verschiedenen Drainspannungswerte geeignet sind, um sicherzustellen, dass ein vorgegebener Schwellwertpegel am Ende einer vorgegebenen Anzahl n von Impulsen erreicht wird.

8. Programmierverfahren nach Anspruch 1, **dadurch gekennzeichnet, dass** die separaten Zellen des Speicherwortes unterschiedliche individuelle Zielschwellwerte in einer asymptotischen Weise zu demjenigen Zeitpunkt angenommen haben, wenn die Programmierung unterbrochen ist.

9. Programmierverfahren nach Anspruch 1, **dadurch gekennzeichnet, dass** die Zellprogrammierungszeit nicht mit der Suche des Schwellwertes zusammenhängt.

10. Programmierverfahren nach Anspruch 1, **dadurch gekennzeichnet, dass** der Zeitpunkt der gleichzeitigen Erhaltung der unterschiedlichen Zielpegel am Ende der Anzahl n von Impulsen gesetzt wird.

11. Programmierverfahren nach Anspruch 10, **dadurch gekennzeichnet, dass** die Anzahl von n Impulsen einheitlich mit einer kongruierenden Genauigkeit und mit der Anzahl n, welche zu einem Minimum hin tendiert, eingestellt wird.

12. Programmierverfahren nach Anspruch 1, bei welchem jeder Drainspannungswert durch einen verschiedenen und entsprechenden Spannungsregler erzeugt wird, wobei die Anzahl von Reglern gleich groß m-1 ist, wobei m die Anzahl der Niveaus der Mehrpegelzellen ist.

## Revendications

1. Procédé de programmation d'un dispositif de mémoire non volatile multiniveaux comprenant une pluralité de cellules de transistor regroupées en mots de mémoire et pourvu de bornes de porte et de drain conventionnelles, dans lequel différentes valeurs de tension de drain sont appliquées en parallèle à des cellules distinctes d'un mot de mémoire pour atteindre différentes valeurs de seuil,
**caractérisé en ce que**
lesdites différentes valeurs de tension de drain sont appliquées aux dites bornes de drain au moyen d'une succession d'impulsions de tension, sont directement proportionnelles aux valeurs de seuil à atteindre pour chaque cellule et sont sélectionnées de sorte que les différentes valeurs de cible desdites cellules distinctes sont simultanément atteintes d'une manière asymptotique dans le temps à la fin d'un même nombre n desdites impulsions de tension de drain ;
une même tension de porte constante étant simultanément appliquée aux bornes de porte desdites cellules de transistor dudit mot de mémoire.

2. Procédé de programmation selon la revendication 1, **caractérisé en ce que** les différentes tensions de drain ont une amplitude constante ou un niveau constant à chaque impulsion.

3. Procédé de programmation selon la revendication 1, **caractérisé en ce que** lesdites impulsions sont des impulsions de durée constante.

4. Procédé de programmation selon la revendication 1, **caractérisé en ce que** lesdites impulsions sont des impulsions de durée décroissante.

5. Procédé de programmation selon la revendication 1, **caractérisé en ce que** lesdites impulsions sont des impulsions de durée variable.

6. Procédé de programmation selon la revendication 1, **caractérisé en ce que** les différentes valeurs de tension de drain correspondent à différentes valeurs de seuil logique des cellules multiniveaux.

7. Procédé de programmation selon la revendication 1, **caractérisé en ce que** lesdites différentes valeurs de tension de drain sont appropriées pour s'assurer qu'un niveau de seuil prédéterminé est atteint à la fin d'un nombre prédéterminé n d'impulsions.

8. Procédé de programmation selon la revendication 1, **caractérisé en ce que** lesdites cellules distinctes dudit mot de mémoire ont pris différentes valeurs individuelles de seuil de cible d'une manière asymptotique, à l'instant même auquel la programmation est interrompue.

9. Procédé de programmation selon la revendication 1, **caractérisé en ce que** le temps de programmation de cellules n'est pas lié au niveau de seuil à atteindre.

10. Procédé de programmation selon la revendication 1, **caractérisé en ce que** le point auquel les différents niveaux de cible sont simultanément atteints est réglé à la fin dudit nombre n d'impulsions.

11. Procédé de programmation selon la revendication 10, **caractérisé en ce que** ledit nombre n d'impulsions est réglé de manière cohérente avec un degré conforme de précision et de sorte que ledit nombre n tende vers un minimum.

12. Procédé de programmation selon la revendication 1, dans lequel chaque valeur de tension de drain est générée par un régulateur de tension différent et correspondant, le nombre de régulateurs étant m-1 où m est le nombre de niveaux des cellules multiniveaux.
